# EUROPÄISCHE PATENTSCHRIFT

(11) **EP 2 036 414 B1**
(45) Veröffentlichungstag und Bekanntmachung des Hinweises auf die Patenterteilung: **27.02.2013**
(21) Anmeldenummer: 07730175.2
(22) Anmeldetag: 14.06.2007
(51) Int. Cl.: H05K 7/14

(54) **BEFESTIGUNGSEINRICHTUNG UND VERFAHREN ZUR BEFESTIGUNG EINER LEITERPLATTE IN EINEM GEHÄUSE**
FIXING DEVICE AND METHOD FOR FIXING A PRINTED CIRCUIT BOARD IN A HOUSING
DISPOSITIF DE FIXATION ET PROCÉDÉ DE FIXATION D'UN CIRCUIT IMPRIMÉ DANS IN BOÎTIER

(30) Priorität: 16.06.2006 DE 102006027750
(43) Veröffentlichungstag der Anmeldung: 18.03.2009
(73) Patentinhaber: Robert Bosch GmbH, 70442 Stuttgart (DE)
(72) Erfinder: WOERNLE, Wolfgang, 72149 Neustetten (DE); LUDWIG, Matthias, 72116 Moessingen (DE); BRUNA FERNANDEZ, Antonio, 72766 Reutlingen (DE)
(86) Internationale Anmeldenummer: PCT/EP2007/055925
(87) Internationale Veröffentlichungsnummer: WO 2007/144417

(56) Entgegenhaltungen:
- DE-A1- 3 908 481
- DE-A1- 19 503 778
- DE-U- 1 918 282
- JP-A- 4 123 487
- US-A- 6 005 775
- US-A1- 2003 147 217

## Beschreibung

Die Erfindung betrifft eine Befestigungseinrichtung zur Befestigung einer Leiterplatte in einem Gehäuse gemäß dem Oberbegriff des Anspruchs 1, sowie ein Verfahren zur Befestigung einer Leiterplatte in einem Gehäuse gemäß dem Oberbegriff des Anspruchs 10.

### Stand der Technik

Bei der Montage von Beschleunigungssensoren von Airbagsystemen, die zur Aufprallerkennung dienen, ist es bereits bekannt, in einem Gehäuse der Beschleunigungssensoren eine Leiterplatte zu montieren, welche die erforderlichen elektronischen Bauelemente und Schaltungen zur Messung der jeweiligen Beschleunigung und zur Auswertung der Messungen trägt. Die Leiterplatten werden dort mit Hilfe einer Einpresstechnik im Gehäuse befestigt, mit der eine lötfreie elektrische und mechanische Verbindung zwischen im Gehäuse eingegossenen, entgegen der Einsetzrichtung der Leiterplatte über einen Gehäuseboden überstehenden metallischen Anschlussstiften und komplementären durchkontaktierten Öffnungen in der Leiterplatte hergestellt wird, indem jeder Anschlussstift beim Einsetzen der Leiterplatte mit Presssitz in die gegenüberliegende Öffnung der Leiterplatte eingepresst wird. Da die Leiterplatte gewöhnlich in ihrer Mitte mit den elektronischen Schaltungen und Bauteilen bestückt ist, sind diese Einpresszonen in der Nähe von Begrenzungsrändem oder Ecken der Leiterplatte angeordnet. Typischerweise sind dabei vier Einpresszonen vorgesehen, von denen jedoch nur zwei zum Anschließen der Leiterplatte an das Gehäuse benötigt werden, während die beiden übrigen nur zur mechanischen Befestigung dienen.

Um sicherzustellen, dass beim Einsetzen der Leiterplatte alle vier fest im Gehäuse fixierten Anschlussstifte genau mit den jeweils gegenüberliegenden Öffnungen der Leiterplatte fluchten, sind die Anforderungen an die Genauigkeiten der Bauteile sowie an die Toleranzen sehr hoch. Bereits Abweichungen im Bereich von 1/10 mm können zu einer Zerstörung der Leiterplatte beim Einsetzen in das Gehäuse führen, da beispielsweise ein durch die Abweichungen verursachtes Abscheren von Metallspäne von den Anschlussstiften bzw. von die Öffnungen umgebenden metallischen Einpresshülsen beim Kontakt mit den auf der Leiterplatte angeordneten Leiterbahnen Kurzschlüsse verursachen kann. Ein höherer Anteil an Ausschuss führt wiederum zu höheren Fertigungskosten.

Ausgehend hiervon liegt der Erfindung die Aufgabe zugrunde, eine Befestigungseinrichtung und ein Verfahren der eingangs genannten Art dahingehend zu verbessern, dass die Anforderungen an die Genauigkeit der Bauteile bzw. an die notwendigen Toleranzen und damit der Ausschuss verringert werden können.

### Offenbarung der Erfindung

Diese Aufgabe wird erfindungsgemäß durch ein im Gehäuseinneren am Gehäuse angeformtes Fixierelement gelöst, das beim Einsetzen der Leiterplatte in das Gehäuse reibschlüssig mit einem gegenüberliegenden äußeren Begrenzungsrand der Leiterplatte in Eingriff tritt.

Der Erfindung liegt der Gedanke zugrunde, nur die beiden zum Anschließen der Leiterplatte an das Gehäuse erforderlichen Kontakte durch Einpressen von Anschlussstiften in komplementäre Öffnungen der Leiterplatte herzustellen und eine darüber hinausgehende mechanische Fixierung der Leiterplatte im Gehäuse mit Hilfe des Fixierelements vorzunehmen, das zum einen entlang seiner gesamten Länge am Gehäuse angeformt werden kann und dadurch im Vergleich zu den Anschlussstiften eine größere mechanische Stabilität besitzt, und das zum anderen so geformt bzw. an die Form der Leiterplatte angepasst werden kann, dass zumindest in einer Richtung geringere Anforderungen an die Toleranzen des Gehäuses und der Leiterplatte gestellt werden.

Um zu verhindern, dass sich die Leiterplatte beim Einsetzen im Bereich des reibschlüssigen Eingriffs zwischen dem Fixierelement und dem gegenüberliegenden Begrenzungsrand verklemmt, weist das Fixierelement vorzugsweise mindestens eine zur Einsetzrichtung parallele dünne Rippe auf, die zweckmäßig mit einer scharfkantigen Scheitellinie versehen ist, so dass sie sich beim Einsetzen der Leiterplatte ins Gehäuse in deren gegenüberliegenden Begrenzungsrand eindrücken oder einschneiden kann.

Da die größten Toleranzen gewöhnlich in einer zur Längsachse der Leiterplatte parallelen Richtung auftreten, ist das Fixierelement gemäß einer bevorzugten Ausgestaltung der Erfindung als Gehäusevorsprung ausgebildet, der zweckmäßig über eine Wand des Gehäuses überstehend quer zur Einsetzrichtung der Leiterplatte ins Gehäuseinnere und in eine randoffene längliche Aussparung der Leiterplatte ragt, wo seine entgegengesetzten Seiten jeweils mit einem gegenüberliegenden Begrenzungsrandabschnitt der Aussparung in der Leiterplatte in Eingriff treten. In diesem Fall weist der Vorsprung zweckmäßig nach entgegengesetzten Seiten überstehende Rippen auf, die sich gegenüberliegende parallele Begrenzungsrandabschnitte der Aussparung eindrücken oder einschneiden, wenn der Vorsprung von unten her in die Aussparung der Leiterplatte eindringt.

Vorteilhafterweise sind die Anschlussstifte in der Nähe eines Begrenzungsrandes der Leiterplatte angeordnet, der zu dem mit dem Fixierelement in Eingriff tretenden Begrenzungsrand entgegengesetzt ist, um für eine gleichmäßige Abstützung der Leiterplatte zu sorgen, vorzugsweise auf mehreren zur Einsetzrichtung senkrechten Auflageflächen, welche die unteren Enden der Anschlussstifte bzw. des Fixierelements ganz oder teilweise umgeben.

### Kurze Beschreibung der Zeichnungen

Im folgenden wird die Erfindung anhand eines in der Zeichnung dargestellten Ausführungsbeispiels näher erläutert. Es zeigen:
Fig. 1: eine perspektivische Oberseitenansicht eines Beschleunigungssensors eines Airbagsystems eines Kraftfahrzeugs mit einem geöffneten, mit einer Leiterplatte bestückten Gehäuse;
Fig. 2: eine vergrößerte perspektivische Oberseitenansicht eines Teils des geöffneten Gehäuses vor dem Einsetzen der Leiterplatte;
Fig. 3: eine Oberseitenansicht eines Teils des geöffneten Gehäuses;
Fig. 4: eine Detailansicht des Ausschnitts X aus Fig. 3 in vergrößertem Maßstab;
Fig. 5: eine vereinfachte Draufsicht auf die Leiterplatte ohne Bauteile und Schaltungen.

### Ausführungsform der Erfindung

Der in der Zeichnung dargestellte Beschleunigungssensor 2 für ein Airbagsystem eines Kraftfahrzeugs besteht im Wesentlichen aus einem Gehäuse 4, einer im Gehäuse 4 montierten Leiterplatte 6, sowie ggf. weiteren Komponenten, die zum Verständnis der vorliegenden Erfindung nicht erforderlich sind und daher zur Vereinfachung der Erläuterung ebenfalls nicht dargestellt und beschrieben sind.

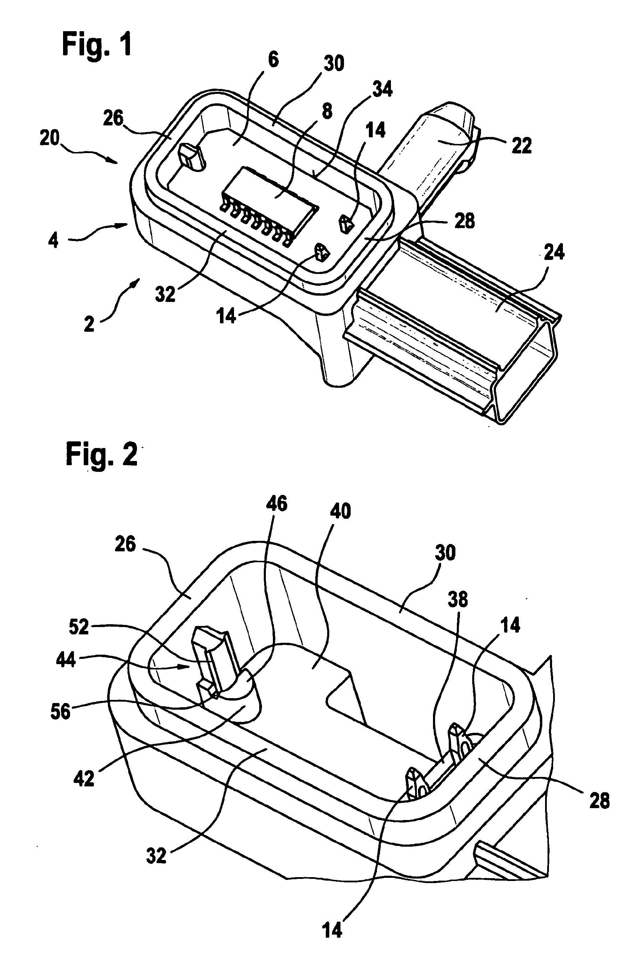

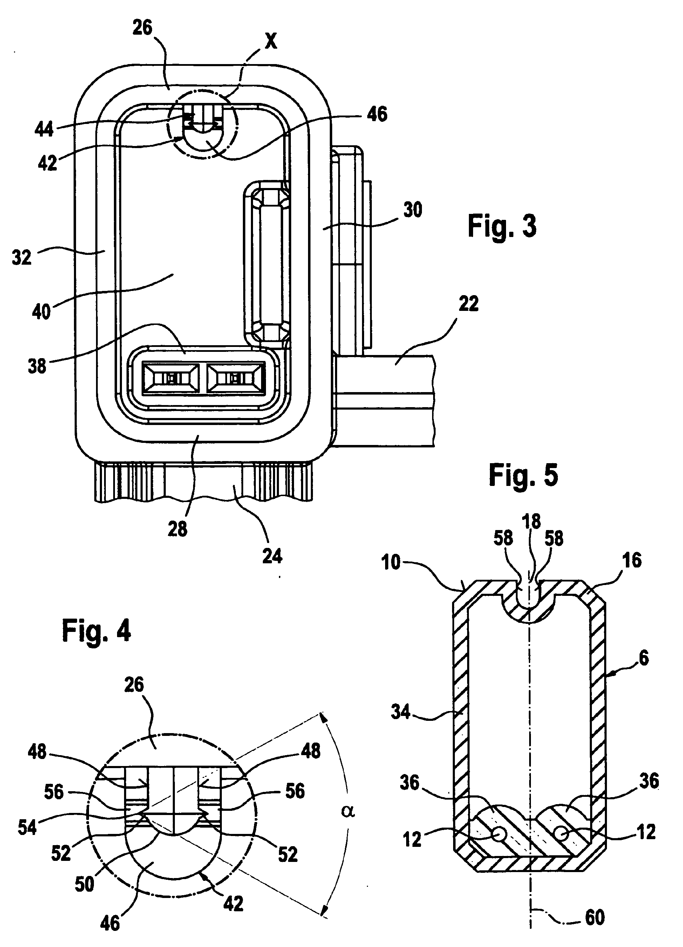

Wie am besten in Fig. 1 dargestellt, ist die Leiterplatte 6 auf ihrer Oberseite mit Leiterbahnen, elektronischen Schaltungen und diskreten Bauelementen bestückt, von denen nur ein zur Auswertung von Beschleunigungsmessungen dienender Prozessor 8 beispielhaft dargestellt ist. Wie am besten in Fig. 5 dargestellt, weist die Leiterplatte 6 einen länglichen rechteckigen Umriss mit abgeschrägten Ecken 10 auf. In der Nähe ihres einen Stirnendes ist die Leiterplatte 6 mit zwei im Querschnitt kreisförmigen durchkontaktierten Durchtrittsöffnungen 12 versehen, die zur Aufnahme zweier komplementärer Anschlussstifte 14 des Gehäuses 4 dienen, während sie an ihrem entgegengesetzten Stirnende in einem nicht mit Leiterbahnen bedruckten Randbereich 16 mit einer im Querschnitt U-förmigen randoffenen Aussparung 18 versehen ist.

Das Gehäuse 4 besteht im Wesentlichen aus einem nach oben zu offenen Gehäuseunterteil 20, das nach der Montage der Leiterplatte 6 und der eventuellen weiteren Komponenten durch einen Deckel (nicht dargestellt) dicht verschließbar ist.

An seiner Außenseite weist der Gehäuseunterteil 20 einen nach einer Seite überstehenden zweigeteilten Befestigungsclip 22 auf, der sich zur Befestigung des Bescheunigungssensors 2 im Kraftfahrzeug in eine entsprechend bemessene Bohrung eines Karosserieteils des Kraftfahrzeugs einführen und darin verrasten lässt, bevor das Gehäuse 4 durch eine zusätzliche Schraube (nicht sichtbar) in der gewünschten Ausrichtung am Karosserieteil fixiert wird. Weiter ist an der Außenseite des Gehäuses 4 eine im rechten Winkel zum Befestigungsclip 22 ausgerichtete, über eine andere Seite des Gehäuseunterteils 20 überstehende Steckerbuchse 24 vorgesehen, die über ein Steckerkabel mit einer Steuerung des Airbagsystems verbindbar ist.

Das Gehäuseinnere weist einen im Wesentlichen rechteckigen Querschnitt auf, dessen Querschnittabmessungen etwas größer als die entsprechenden Abmessungen der Leiterplatte 6 sind, deren Ausrichtung während und nach dem Einsetzen in das Gehäuse 4 zu einer von der Gehäuseöffnung aufgespannten Ebene parallel ist. Das Gehäuseinnere wird im Wesentlichen von zwei Stirnwänden 26, 28 und zwei Längsseitenwänden 30, 32 begrenzt, die zur Aufnahme des Deckels um die Gehäuseöffnung herum stufenförmig abgesetzt sind und deren Innen- und Außenseiten parallel zu einer Einsetzrichtung ausgerichtet sind, entlang von welcher die Leiterplatte 6 beim Einsetzen durch die Gehäuseöffnung ins Gehäuseinnere eingeführt wird. Nach dem Einsetzen der Leiterplatte 6 in das Gehäuse 4 ist ihr äußerer Begrenzungsrand 34 in einem geringen Abstand von den Innenseiten der Wände 26, 28, 30, 32 angeordnet.

In den Kunststoff des Gehäuses 4 sind zwei im rechten Winkel abgebogene, im Wesentlichen parallel im Abstand nebeneinander liegende elektrische Kontaktelemente eingebettet, die beim Spritzgießen des Gehäuses 4 so in dieses eingeformt werden, dass ihre nicht von Kunststoff umhüllten Endabschnitte jeweils paarweise ins Innere der Steckerbuchse 24 bzw. ins Innere des Gehäuses 4 ragen.

Die nach oben ins Innere des Gehäuses überstehenden Endabschnitte der Kontaktelemente bilden die beiden Anschlussstifte 14, die beim Einsetzen der Leiterplatte 6 in das Gehäuse 4 unter Herstellung einer lötfreien elektrischen und mechanischen Verbindung zwischen dem Gehäuse 4 und der Leiterplatte 6 von unten her in die von metallischen Einpresshülsen und Lötaugen 36 (Fig. 5) umgebenen Öffnungen 12 in der Leiterplatte 6 eingepresst werden, so dass ihre freien Enden nach oben über die Leiterplatte 6 überstehen und an die Enden angrenzende Kontaktabschnitte mit Presspassung in den Einpresshülsen der Leiterplatte 6 sitzen. Um das Einführen der Anschlussstifte 14 in die Öffnungen 12 der Leiterplatte 6 zu erleichtern, sind ihre freien Enden zu einer abgeflachten Spitze verjüngt.

Die beiden Anschlussstifte 14 stehen über einen einstückig mit dem Gehäuseunterteil 20 ausgebildeten Tragsockel 38 über, der als Auflage für die Leiterplatte 6 dient und über einen Boden 40 bzw. über die Innenseite der zur Steckerbuchse 24 benachbarten Stirnwand 28 des Gehäuses 4 ins Gehäuseinnere übersteht, wobei seine ebene Oberseite im Abstand vom Boden 40 angeordnet ist und um die Anschlussstifte 14 herum eine Auflagefläche für einen die Öffnungen 12 umgebenden Teil der Leiterplatte 6 bildet.

An der Innenseite der von der Steckerbuchse 24 abgewandten Stirnwand 26 des Gehäuses 4 ist angrenzend an den Boden 40 ebenfalls ein als Auflage für die Leiterplatte dienender Tragsockel 42 mit U-förmigem Umriss angeformt, dessen im Wesentlichen ebene Oberseite vom Boden 40 denselben Abstand wie die Oberseite des Tragsockels 38 aufweist. Über der Oberseite des Tragsockels 42 steht ein einstückig mit dem Gehäuseunterteil 20 ausgebildeter Vorsprung 44 ins Gehäuseinnere über, der zur Stabilisierung an der Innenseite der Stirnwand 26 angeformt ist und abgesehen vom verjüngten oberen Ende einen konstanten, ebenfalls etwa U-förmigen Umriss aufweist. Die Querschnittsabmessungen des Vorsprungs 44 sind kleiner als die Querschnittsabmessungen des Tragsockels 42, so dass an der Oberseite des Tragsockels 42 um den Vorsprung 44 herum eine ebene Schulter 46 gebildet wird, die als Auflagefläche für eine ebene Unterseite eines die Aussparung 18 umgebenden Teils des Randbereichs 16 der Leiterplatte 6 dient.

Wie am besten in Fig. 4 dargestellt, weist der Vorsprung 44 zwischen zwei parallelen Seitenflächen 48 und einem ins Gehäuseinnere weisenden gerundeten vorderen Stirnende 50 zwei nach entgegengesetzten Seiten über die Seitenflächen 48 überstehende Rippen 52 auf. Die beiden Rippen 52 werden jeweils von zwei ebenen Oberflächen begrenzt, die miteinander einen Winkel α von 60 Grad einschließen und entlang einer zur Einsetzrichtung parallelen Scheitellinie 54 aneinander stoßen.

Um sicherzustellen, dass eine flächige Auflage der Unterseite der Leiterplatte 6 auf der Schulter 46 nicht durch einen ggf. beim Formen des Gehäuseunterteils 20 entstehenden gekrümmten Übergang zwischen den Rippen 52 bzw. deren Scheitellinien 54 und der Schulter 46 behindert wird, weist die Schulter 46 um das untere Ende jeder Rippe 52 herum eine eingeformte Vertiefung 56 auf, in die sich die Rippe 52 von oben her hinein erstreckt.

Wie am besten in Fig. 5 dargestellt, weist die im Querschnitt U-förmige Aussparung 18 in dem zur Stirnwand 26 benachbarten Stirnende der Leiterplatte 16 weist zwei nicht metallisierte parallele seitliche Begrenzungsrandabschnitte 58 auf. Deren Abstand ist so auf den Abstand der Scheitellinien 54 der beiden Rippen 52 abgestimmt, dass sich die letzteren jeweils mit einem an die Scheitellinien 54 angrenzenden Teil etwa 0,1 bis 0,2 mm weit in die gegenüberliegenden Begrenzungsrandabschnitte 58 eindrücken oder einschneiden, wenn die Leiterplatte 6 ins Gehäuseinnere eingesetzt und dabei von oben her mit Druck beaufschlagt wird, um die Anschlussstifte 14 in die Öffnungen 12 zu pressen. Dabei dringt der Vorsprung 44 von unten her in die Aussparung 18 ein, wobei es im Bereich der Rippen 52 zu einem reibschlüssigen mechanischen Eingriff zwischen dem Vorsprung 44 und dem Begrenzungsrand 34 der Leiterplatte 6 kommt, der für eine Fixierung der letzteren auf der von der Schulter 46 gebildeten Auflagefläche sorgt.

Da sich die Rippen 52 in der Aussparung 18 an einer beliebigen Stelle entlang der parallelen Begrenzungsrandabschnitte 58 in das Material der Leiterplatte 6 eindrücken oder einschneiden können, lassen sich zudem Toleranzen der Leiterplatte 6 und des Gehäuses 4 in Richtung einer Längsachse 60 der Leiterplatte 6 ausgleichen.

Durch eine sorgfältige Abstimmung des Abstands zwischen den Scheitellinien 54 der beiden Rippen 52 auf den Abstand zwischen den gegenüberliegenden Begrenzungsrandabschnitten 58 der Aussparung 18 kann darüber hinaus erreicht werden, dass sich das zur Stirnwand 26 benachbarte Stirnende der Leiterplatte 6 unter Verschwenken um eine quer zur Längsachse 60 durch die beiden Einpresszonen verlaufende Achse geringfügig am Vorsprung 44 entlang bewegen kann. Dadurch wird ein mechanischer Tiefpass realisiert, mit dem sich hochfrequente Beschleunigungen bzw. hochfrequente Signalanteile in einem vom Beschleunigungssensor 2 an die Steuerung des Airbagsystems übermittelten Signal unterdrücken lassen und ein sogenanntes "Clipping" des Beschleunigungssensors 2 verhindert werden kann.

## Patentansprüche

1. Befestigungseinrichtung zur Befestigung einer Leiterplatte in einem Gehäuse, umfassend im Gehäuseinneren angeordnete, entgegen der Einsetzrichtung der Leiterplatte ausgerichtete Anschlussstifte sowie in der Leiterplatte ausgebildete durchkontaktierte Öffnungen, in welche die Anschlussstifte beim Einsetzen der Leiterplatte in das Gehäuse unter Herstellung einer lötfreien elektrischen und mechanischen Verbindung zwischen dem Gehäuse und der Leiterplatte einpressbar sind, **gekennzeichnet durch** einen im Gehäuseinneren am Gehäuse (4) angeformten Vorsprung (44), der beim Einsetzen der Leiterplatte (6) in das Gehäuse (4) reibschlüssig mit einem gegenüberliegenden äußeren Begrenzungsrand (34) der Leiterplatte (6) in Eingriff tritt.

2. Befestigungseinrichtung nach Anspruch 1, **dadurch gekennzeichnet, dass** der Vorsprung (44) mindestens eine zur Einsetzrichtung parallele dünne Rippe (52) aufweist, entlang von der er mit dem Begrenzungsrand (34) der Leiterplatte (6) in Eingriff tritt.

3. Befestigungseinrichtung nach Anspruch 2, **dadurch gekennzeichnet, dass** die Rippe (52) eine scharfkantige Schneide oder Scheitellinie (52) aufweist, die sich in den Begrenzungsrand (34) eindrücken oder einschneiden kann.

4. Befestigungseinrichtung nach einem der vorangehenden Ansprüche, **dadurch gekennzeichnet, dass** der Vorsprung (44) quer zur Einsetzrichtung der Leiterplatte (6) ins Gehäuseinnere und in eine randoffenen Aussparung (18) der Leiterplatte (6) ragt.

5. Befestigungseinrichtung nach Anspruch 4, **dadurch gekennzeichnet, dass** der Vorsprung (44) nach entgegengesetzten Seiten überstehende, zur Einsetzrichtung parallele Rippen (52) aufweist, die innerhalb der Aussparung (18) mit gegenüberliegenden Abschnitten (58) des Begrenzungsrandes (34) in Eingriff treten.

6. Befestigungseinrichtung nach Anspruch 5, **dadurch gekennzeichnet, dass** die gegenüberliegenden Abschnitte (58) des Begrenzungsrandes (34) parallel zueinander ausgerichtet sind.

7. Befestigungseinrichtung nach einem der Ansprüche 4 bis 6, **dadurch gekennzeichnet, dass** die Aussparung (18) symmetrisch zu einer Längsmittelachse (60) der Leiterplatte (6) ist.

8. Befestigungseinrichtung nach einem der vorangehenden Ansprüche, **dadurch gekennzeichnet, dass** der Vorsprung (44) über die Innenseite einer Stirnwand (26) des Gehäuses (4) übersteht.

9. Befestigungseinrichtung nach einem der vorangehenden Ansprüche, **dadurch gekennzeichnet, dass** die Öffnungen (12) für die Anschlussstifte (14) in einem Teil der Leiterplatte (6) angeordnet sind, der zu einem mit dem Vorsprung (44) in Eingriff tretenden Abschnitt (58) des Begrenzungsrandes (34) entgegengesetzt ist.

10. Befestigungseinrichtung nach einem der vorangehenden Ansprüche, **dadurch gekennzeichnet, dass** die Anschlussstifte (14) und der Vorsprung (44) jeweils über eine zur Einsetzrichtung senkrechte Auflagefläche eines Tragsockels (38, 40) überstehen.

11. Verfahren zur Befestigung einer Leiterplatte in einem Gehäuse, bei dem beim Einsetzen der Leiterplatte in das Gehäuse über das Gehäuse überstehende Anschlussstifte in durchkontaktierte Öffnungen der Leiterplatte eingepresst werden, um eine lötfreie elektrische und mechanische Verbindung zwischen dem Gehäuse und der Leiterplatte herzustellen, **dadurch gekennzeichnet, dass** ein im Gehäuseinneren am Gehäuse (4) angeformter Vorsprung (44) beim Einsetzen der Leiterplatte (6) in das Gehäuse (4) reibschlüssig mit einem gegenüberliegenden äußeren Begrenzungsrand (34) der Leiterplatte (6) in Eingriff gebracht wird.

## Claims

1. Mounting device for mounting a printed circuit board in a housing, comprising connection pins, which are arranged in the housing interior and are oriented counter to the insertion direction of the printed circuit board, and also plated-through openings which are formed in the printed circuit board and into which the connection pins can be pressed, when the printed circuit board is inserted into the housing, so as to produce a solder-free electrical and mechanical connection between the housing and the printed circuit board, **characterized by** a projection (44) which is integrally formed on the housing (4) in the housing interior and which engages with an opposite outer boundary edge (34) of the printed circuit board (6) with a friction-fit when the printed circuit board (6) is inserted into the housing (4).

2. Mounting device according to Claim 1, **characterized in that** the projection (44) has at least one thin rib (52) which is parallel to the insertion direction, the said projection engaging with the boundary edge (34) of the printed circuit board (6) along the said thin rib.

3. Mounting device according to Claim 2, **characterized in that** the rib (52) has a sharp edge or apex line (52) which can be pushed into or can cut into the boundary edge (34).

4. Mounting device according to one of the preceding claims, **characterized in that** the projection (44) projects transverse to the insertion direction of the printed circuit board (6) into the housing interior and into a cutout (18) in the printed circuit board (6), which cutout is open at the edge.

5. Mounting device according to Claim 4, **characterized in that** the projection (44) has ribs (52) which project towards opposite sides and are parallel to the insertion direction and engage with opposite sections (58) of the boundary edge (34) within the cutout (18).

6. Mounting device according to Claim 5, **characterized in that** the opposite sections (58) of the boundary edge (34) are oriented parallel to one another.

7. Mounting device according to one of Claims 4 to 6, **characterized in that** the cutout (18) is symmetrical to a longitudinal centre axis (60) of the printed circuit board (6).

8. Mounting device according to one of the preceding claims, **characterized in that** the projection (44) projects beyond the inner face of an end wall (26) of the housing (4).

9. Mounting device according to one of the preceding claims, **characterized in that** the openings (12) for the connection pins (14) are arranged in a portion of the printed circuit board (6) which is opposite a section (58) of the boundary edge (34) which engages with the projection (44).

10. Mounting device according to one of the preceding claims, **characterized in that** the connection pins (14) and the projection (44) each project beyond a bearing surface of a supporting base (38, 40), the said bearing surface being perpendicular to the insertion direction.

11. Method for mounting a printed circuit board in a housing, in which method connection pins which project beyond the housing are pressed into plated-through openings in the printed circuit board, when the printed circuit board is inserted into the housing, in order to establish a solder-free electrical and mechanical connection between the housing and the printed circuit board, **characterized in that** a projection (44) which is integrally formed on the housing (4) in the housing interior engages with an opposite outer boundary edge (34) of the printed circuit board (6) with a friction-fit when the printed circuit board (6) is inserted into the housing (4).

## Revendications

1. Dispositif de fixation pour la fixation d'une carte à circuits imprimés dans un boîtier, comprenant des broches de connexion disposées à l'intérieur du boîtier, orientées à l'encontre de la direction d'insertion de la carte à circuits imprimés, ainsi que des ouvertures de contact réalisées dans la carte à circuits imprimés, dans lesquelles ouvertures les broches de connexion peuvent être enfoncées lors de l'insertion de la carte à circuits imprimés dans le boîtier en créant une connexion électrique et mécanique sans brasage entre le boîtier et la carte à circuits imprimés, **caractérisé par** une saillie (44) façonnée au niveau du boîtier (4) dans l'intérieur du boîtier, qui, lors de l'insertion de la carte à circuits imprimés (6) dans le boîtier (4), entre en prise par engagement par friction avec un bord de limitation extérieur (34) opposé de la carte à circuits imprimés (6).

2. Dispositif de fixation selon la revendication 1, **caractérisé en ce que** la saillie (44) présente au moins une nervure mince (52) parallèle à la direction d'insertion, le long de laquelle elle vient en prise avec le bord de limitation (34) de la carte à circuits imprimés (16).

3. Dispositif de fixation selon la revendication 2, **caractérisé en ce que** la nervure (52) présente un tranchant ou une ligne de tranchant (52) à arête vive, qui peut s'enfoncer par pressage ou creusage dans le bord de limitation (34).

4. Dispositif de fixation selon l'une quelconque des revendications précédentes, **caractérisé en ce que** la saillie (44) pénètre transversalement à la direction d'insertion de la carte à circuits imprimés (16) dans l'intérieur du boîtier et dans un évidement à bords ouverts (18) de la carte à circuits imprimés (6).

5. Dispositif de fixation selon la revendication 4, **caractérisé en ce que** la saillie (44) présente des nervures (52) parallèles à la direction d'insertion, dépassant vers des côtés opposés, qui viennent en prise à l'intérieur de l'évidement (18) avec des portions opposées (58) du bord de limitation (34).

6. Dispositif de fixation selon la revendication 5, **caractérisé en ce que** les portions opposées (58) du bord de limitation (34) sont orientées parallèlement les unes aux autres.

7. Dispositif de fixation selon l'une quelconque des revendications 4 à 6, **caractérisé en ce que** l'évidement (18) est symétrique par rapport à un axe médian longitudinal (60) de la carte à circuits imprimés (6).

8. Dispositif de fixation selon l'une quelconque des revendications précédentes, **caractérisé en ce que** la saillie (44) dépasse au-delà du côté intérieur d'une paroi frontale (26) du boîtier (4).

9. Dispositif de fixation selon l'une quelconque des revendications précédentes, **caractérisé en ce que** les ouvertures (12) pour les broches de connexion (14) sont disposées dans une partie de la carte à circuits imprimés (6) qui est opposée à une portion (58) du bord de limitation (34) en prise avec la saillie (44).

10. Dispositif de fixation selon l'une quelconque des revendications précédentes, **caractérisé en ce que** les broches de connexion (14) et la saillie (44) dépassent à chaque fois au-delà d'une surface d'appui d'un socle de support (38, 40), perpendiculaire à la direction d'insertion.

11. Procédé de fixation d'une carte à circuits imprimés dans un boîtier, dans lequel, lors de l'insertion de la carte à circuits imprimés dans le boîtier des broches de connexion saillant au-delà du boîtier sont enfoncées dans des ouvertures de contact de la carte à circuits imprimés afin de créer une connexion électrique et mécanique sans brasage entre le boîtier et la carte à circuits imprimés, **caractérisé en ce qu'**une saillie (44) façonnée au niveau du boîtier (4) dans l'intérieur du boîtier est amenée en prise par engagement par friction avec un bord de limitation extérieur opposé (34) de la carte à circuits imprimés (6) lors de l'insertion de la carte à circuits imprimés (6) dans le boîtier (4).
